# EUROPÄISCHE PATENTSCHRIFT

(11) **EP 2 371 991 B1**
(45) Veröffentlichungstag und Bekanntmachung des Hinweises auf die Patenterteilung: **30.01.2013**
(21) Anmeldenummer: 10157915.9
(22) Anmeldetag: 26.03.2010
(51) Int. Cl.: C23C 14/24

(54) **Verfahren zum diskontinuierlichen Nachfüllen einer Selenverdampferkammer**
Method for discontinuous refilling of a selenium evaporation chamber
Procédé de remplissage discontinu d'une chambre d'évaporateur de sélénium

(43) Veröffentlichungstag der Anmeldung: 05.10.2011
(73) Patentinhaber: Saint-Gobain Glass France, 92400 Courbevoie (FR)
(72) Erfinder: Boger, Raimund, 89231 Neu-Ulm (DE); Götze, Thomas, 04886, Großtreben (DE); Jahnke, Andreas, 81827, München (DE)
(74) Vertreter: Lendvai, Tomas

(56) Entgegenhaltungen:
- EP-A1- 2 025 773
- JP-A- 2008 248 362

## Beschreibung

Die Erfindung betrifft ein Verfahren und eine Vorrichtung zum diskontinuierlichen Nachfüllen einer Selenverdampferkammer.

Einer der Vorteile von Dünnschichtsolarzellen gegenüber Solarzellen mit kristallinem oder polykristallinem Silizium ist ihre große Flexibilität im Hinblick auf das verwendete Substrat und die Größe des zu beschichtenden Substrats. So lassen sich Dünnschichtsolarzellen auch großflächig auf Glasscheiben oder auf flexiblen Materialien, wie beispielsweise Kunststoffen herstellen.

Photovoltaische Schichtsysteme zur direkten Umwandlung von Sonnenstrahlung in elektrische Energie sind bekannt. Die Materialien und die Anordnung der Schichten sind so abgestimmt, dass einfallende Strahlung von einer oder mehreren halbleitenden Schichten mit möglichst hoher Strahlungsausbeute direkt in elektrischen Strom umgewandelt wird. Photovoltaische und flächig ausgedehnte Schichtsysteme werden als Solarzellen bezeichnet.

Solarzellen enthalten in allen Fällen Halbleitermaterial. Solarzellen, die zur Bereitstellung einer ausreichenden mechanischen Festigkeit Trägersubstrate benötigen, werden als Dünnschichtsolarzellen bezeichnet. Aufgrund der physikalischen Eigenschaften und der technologischen Handhabbarkeit sind Dünnschichtsysteme mit amorphen, mikromorphen oder polykristallinem Silizium, Cadmium-Tellurid (CdTe), Gallium-Arsenid (GaAs) oder Kupfer-Indium(Gallium)-Schwefel/Selen (Cl(G)S) besonders für Solarzellen geeignet.

Bekannte Trägersubstrate für Dünnschichtsolarzellen enthalten anorganisches Glas, Polymere oder Metalllegierungen und können in Abhängigkeit von Schichtdicke und Materialeigenschaften als starre Platten oder biegsame Folien ausgestaltet sein. Aufgrund der weitreichend verfügbaren Trägersubstrate und einer einfachen monolithischen Integration können großflächige Anordnungen von Dünnschichtsolarzellen kostengünstig hergestellt werden.

Dünnschichtsolarzellen zeigen allerdings im Vergleich zu Solarzellen mit kristallinem oder multikristallinem Silizium eine geringere Strahlungsausbeute und einen geringeren elektrischen Wirkungsgrad. Dünnschichtsolarzellen basierend auf Cu(In, Ga)(S, Se)₂ zeigen elektrische Wirkungsgrade, die annährend mit multikristallinen Silizium-Solarzellen vergleichbar sind. Cl(G)S-Dünnschichtsolarzellen benötigen eine Pufferschicht zwischen typisch p-leitendem Cl(G)S-Absorber und typisch n-leitender Frontelektrode, die üblicherweise Zinkoxid (Zn0) umfasst. Die Pufferschicht kann eine elektronische Anpassung zwischen Absorbermaterial und Frontelektrode bewirken. Die Pufferschicht enthält beispielsweise eine Cadmium-Schwefel-Verbindung. Eine Rückelektrode mit beispielsweise Molybdän wird direkt auf Trägersubstraten abgeschieden.

Eine elektrische Schaltung von mehreren Solarzellen wird als Photovoltaik- oder Solarmodul bezeichnet. Die Schaltung von Solarzellen wird in bekannten witterungsstabilen Aufbauten dauerhaft vor Umwelteinflüssen geschützt. Üblicherweise sind eisenarme Natron-Kalk-Gläser und haftvermittelnde Polymerfolien mit den Solarzellen zu einem bewitterungsstabilen Photovoltaikmodul verbunden. Die Photovoltaikmodule können über Anschlussdosen in eine Schaltung von mehreren Photovoltaikmodulen eingebunden sein. Die Schaltung von Photovoltaikmodulen ist über bekannte Leistungselektronik mit dem öffentlichen Versorgungsnetz oder einer autarken elektrischen Energieversorgung verbunden.

Die Abscheidung von Selen, insbesondere bei der sequenziellen Abscheidung der Komponenten der CIS-Schicht, erfordert in der Regel ein Vakuum. Dies bedingt eine vollständige Unterbrechung des Prozesses, wenn das zur Abscheidung vorgesehene Selen aufgebraucht ist. Die gesamte Apparatur muss belüftet, abgekühlt, Selen in die Apparatur nachgefüllt und anschließend wieder evakuiert und erwärmt werden. Diese Schritte sind sehr zeitaufwendig und bei einer großtechnischen Produktion sehr kostenintensiv, da der Verdampfungsprozess jeweils für einen längeren Zeitraum unterbrochen wird. Durch diese notwendigen Schritte, insbesondere die Belüftungs-und Abkühlprozesse, ist eine kontinuierliche Selenbedampfung nicht möglich. Da die Größe der Verdampfungsvorrichtung und die Selendampfkonzentration wichtige Prozessparameter sind, kann zudem nicht beliebig viel Selen in n die Selenverdampferkammer eingebracht werden. Zudem ist die Geschwindigkeit einer gleichmäßigen Selenverdampfung auch von einem definierten Oberfläche- zu Volumenverhältnis des zu verdampfenden Selens abhängig. Ein weiterer wichtiger Faktor bei der Befüllung des Selenverdampfers sind die in der Anlage vorhandenen Selendämpfe. Diese Selendämpfe können leicht an einer Nachfüllvorrichtung kondensieren und die Nachfüllvorrichtung zusetzen. Insbesondere die im Vergleich zur eigentlichen Selenverdampferkammer vorliegende niedrigere Temperatur fördert die Kondensation des dampfförmigen Selens.

WO 2007/077171 A2 offenbart ein Verfahren zur Herstellung von Chalkopyritschichten in CIGSS - Solarzellen. Dazu wird ein Substrat mit Precursorn beschichtet und zusammen mit Schwefel und Selen in eine dicht verschließbare Reaktionsbox gelegt. Die Reaktionsbox wird in einen RTP- Ofen gebracht, evakuiert und auf die notwendige Reaktionstemperatur erhitzt.

EP 0 715 358 A2 offenbart ein Verfahren zur Herstellung einer Solarzelle mit Chalkopyrit-Absorberschicht. Im Verfahren wird durch Zugabe von Na, K oder Li ein gewünschter Alkaligehalt eingestellt. Eine zusätzliche Diffusion von Alkaliionen aus dem Substrat wird durch eine Diffusionssperrschicht verhindert. Selen und/oder Schwefel werden im Verfahren zumindest teilweise über eine entsprechende schwefel-oder selenhaltige Atmosphäre zugeführt.

WO 2009/034131 A2 offenbart ein Verfahren zum Abscheiden von Chalkogenen in dünnen Schichten. Das Selen wird als Festkörper in einem Vorratsgefäß gelagert und von dort in eine Kammer überführt und verdampft. Die Kammer ist am Eingang mit einem Verschluss versehen, um ein Entweichen der Selendämpfe in das Vorratsgefäß zu vermeiden.

US 4,880,960 A offenbart ein Verfahren zur Vakuumverdampfung und eine Vorrichtung zur Beschichtung eines beweglichen Substrats. Das aufzutragende Material wird kontinuierlich aus einem Vorratsbehälter über ein Ventil in eine Vakuumkammer überführt, erhitzt und dort auf ein auf Rollen gelagertes Substrat aufgedampft. Die Erfindung offenbart die Bedampfung von Kohlefasern mit Magnesium.

WO 2009/010468 A1 offenbart eine Vorrichtung zum Verdampfen fester Materialien. Das feste Material, beispielsweise Selen, wird in einen ersten Tiegel gebracht und aufgeschmolzen. Das geschmolzene Material fließt über eine Transportvorrichtung in einen zweiten Tiegel. In diesem Tiegel wird das geschmolzene Material verdampft und auf ein Substrat gebracht. Das Einfüllen des Materials erfolgt in ein Reservoir, das nach dem Befüllen geschlossen, sowie anschließend evakuiert wird und über ein Ventil das feste Material zum ersten Tiegel durchlässt.

Die Aufgabe der vorliegenden Erfindung liegt darin, ein Verfahren bereitzustellen, das ein diskontinuierliches Nachfüllen einer Selenverdampferkammer ermöglicht, ohne den eigentlichen Prozess der Selenverdampfung zu unterbrechen.

Die Aufgabe der vorliegenden Erfindung wird erfindungsgemäß durch ein Verfahren zum diskontinuierlichen Nachfüllen einer Selenverdampferkammer gemäß Anspruch 1 gelöst. Bevorzugte Ausführungen gehen aus den Unteransprüchen hervor.

Eine erfindungsgemäße Vorrichtung und deren Verwendung gehen aus weiteren Ansprüchen hervor.

Das erfindungsgemäße Verfahren zum diskontinuierlichen Nachfüllen einer Selenverdampferkammer umfasst in einem ersten Schritt das Befüllen eines Dosierbehälters in einer Vorkammer mit Selen. Das Befüllen erfolgt bevorzugt über eine verschließbare, temperatur- und vakuumstabile Öffnung. Dosierbehälter umfassen im Rahmen der Erfindung bevorzugt Löffel und löffelähnliche Gegenstände. Die verschließbare Öffnung wird wieder geschlossen und in der Vorkammer wird ein Vakuum, bevorzugt von 5 mbar bis 10-' mbar, erzeugt. Der Dosierbehälter wird anschließend horizontal verschoben und über eine in der Vorkammer befindliche Heizung positioniert. Das Selen wird in dem Dosierbehälter erwärmt und verflüssigt. Im nächsten Schritt wird ein beheizter Vakuumschieber zwischen der Vorkammer und einer beheizten Gießkammer geöffnet. Der Dosierbehälter wird in die beheizte Gießkammer geschoben. Anschließend wird ein beheizter Vakuumschieber zwischen der beheizten Gießkammer und einer beheizten Verdampferkammer geöffnet. Das Selen wird bevorzugt durch Drehen des Dosierbehälters in einen beheizten Trichter überführt. Das Selen wird aus dem beheizten Trichter in der beheizten Gießkammer über einen beheizten Trichter in der beheizten Verdampferkammer in einen Selenverdampfer überführt. Die beheizte Verdampferkammer und/oder die beheizte Gießkammer werden bevorzugt auf einen Druck von 10-² mbar bis 10-' mbar evakuiert.

Die Vorkammer und/oder die Gießkammer werden bevorzugt auf 150 ^{f}l5 bis 250 ^{f}l5 erwärmt.

Die Vorkammer, die Gießkammer und/oder die Verdampferkammer werden bevorzugt auf weniger als 5 mbar, bevorzugt auf weniger als 0,1 mbar, besonders bevorzugt auf weniger als 10⁻³ mbar evakuiert.

Die Verdampferkammer wird bevorzugt auf 190 °C bis 280 °C, besonders bevorzugt 200 °C bis 250 °C erwärmt.

Die Aufgabe der Erfindung wird des Weiteren durch eine Vorrichtung zum Nachfüllen und Befüllen einer Selenverdampferkammer gelöst. Die Selenverdampferkammer umfasst mindestens eine Vorkammer mit einem an einer Dichtung befestigten, horizontal freibeweglichen, Dosierbehälter. Der Dosierbehälter umfasst bevorzugt Löffel und löffelähnliche Gegenstände. Die Länge des Löffelstiels ist bevorzugt so gewählt, dass der Löffel sowohl in der Vorkammer als auch in der unten beschriebenen Gießkammer in mindestens einer Achse, bevorzugt horizontal, frei beweglich ist. Der Löffel ist bevorzugt aus Metallen und/oder Legierungen davon, bevorzugt Eisen, Chrom, Vanadium, Nickel, Kobalt, Titan, Aluminium, besonders bevorzugt aus Stahl gefertigt. Die Vorkammer enthält mindestens eine Heizung. Die Heizung ist bevorzugt so dimensioniert, dass die abgegebene Strahlungswärme ausreicht, um das im Dosierbehälter befindliche Selen zu verflüssigen. Der Vorkammer schließt sich eine beheizte Gießkammer mit einem am Boden der Gießkammer angeordneten beheizten Trichter an. Die beheizte Gießkammer ist über mindestens einen verschließbaren, beheizten Vakuumschieber mit der Vorkammer verbunden. Die beheizte Gießkammer enthält bevorzugt eine Heizvorrichtung. Die Vorkammer und/oder die Gießkammer weisen bevorzugt Anschlüsse zum Anlegen eines Vakuums auf. Die Vorrichtung umfasst des Weiteren eine beheizte Selenverdampferkammer mit einem am Boden angeordneten Selenverdampfer und einem auf dem Selenverdampfer angeordneten beheizten Trichter. Mindestens ein beheizter Vakuumschieber verbindet die beheizte Gießkammer und die beheizte Selenverdampferkammer. Der beheizte Vakuumschieber stellt eine verschließbare Verbindung zwischen dem beheizten Trichter in der Gießkammer und dem beheizten Trichter in der Selenverdampferkammer bereit. Die Temperierung des geheizten Vakuumschiebers kann am Bauteil selbst oder über die benachbarten Baugruppen erfolgen. Die Heizung ist bevorzugt in Form einer elektrischen Widerstandsheizung am oder innerhalb des Vakuumschiebers angeordnet. Der geheizte Vakuumschieber enthält bevorzugt eine Öffnung mit einem Durchmesser von 15 mm bis 50 mm, besonders bevorzugt 30 mm bis 40 mm.

Der Dosierbehälter enthält bevorzugt ein Dampfschild. Der Dampfschild ist bevorzugt nahe dem Übergang vom Dosierbehälterlöffel zum Dosierbehälterstiel angeordnet. Die Querschnittsfläche des Dampfschilds entspricht bevorzugt mehr als 90 %, besonders bevorzugt mehr als 95 % der Querschnittsfläche der Vorkammer. Der Ausdruck "Querschnittsfläche" bezieht sich im Rahmen der Erfindung auf die minimale Schnittfläche innerhalb der Vorkammer parallel zum beheizten Vakuumschieber zwischen der Vorkammer und der Gießkammer. Der Dampfschild enthält Metalle und/oder Legierungen davon, bevorzugt Eisen, Chrom, Vanadium, Nickel, Kobalt, Titan, Aluminium, besonders bevorzugt Stahl.

Der Dosierbehälter enthält bevorzugt eine Email- oder Teflonbeschichtung.

Die Heizung enthält bevorzugt einen Infrarotheizer oder Infrarotstrahler.

Die Vorkammer enthält bevorzugt eine vakuum- und temperaturstabile, verschließbare Öffnung.

Die Vorkammer enthält bevorzugt Ventile zum Evakuieren und/oder Belüften.

Der Dosierbehälter weist bevorzugt ein Füllvolumen von 30 cm³ bis 250 cm³, bevorzugt 50 cm³ bis 150 cm³ auf.

Die Erfindung umfasst des Weiteren die Verwendung der Vorrichtung zum Nachfüllen einer Selenverdampferkammer, insbesondere bei der Herstellung von Dünnschichtsolarzellen.

Die Erfindung umfasst des Weiteren die Verwendung der erfindungsgemäßen Vorrichtung zum diskontinuierlichen Nachfüllen einer Verdampferkammer von Schwefel, Selen, Tellur und/oder Gemischen davon. Die erfindungsgemäße Vorrichtung und das erfindungsgemäße Verfahren zum Nachfüllen einer Selenverdampferkammer eignen sich auch zum Nachfüllen einer Verdampferkammer der Elemente Schwefel, Tellur oder Gemische der Verbindungen Schwefel, Selen und/oder Tellur. Die erfindungsgemäße Selenverdampferkammer kann im Sinne der Erfindung analog auch als Verdampferkammer der Elemente Schwefel oder Tellur verwendet werden.

Im Folgenden wird die Erfindung anhand von Zeichnungen näher erläutert. Die Zeichnungen sind rein schematische Darstellungen und nicht maßstabsgetreu. Die Zeichnungen schränken die Erfindung in keiner Weise ein.

Es zeigen:
Figur 1 einen Querschnitt der erfindungsgemäßen Vorrichtung (1) zum Nachfüllen und Befüllen einer Selenverdampferkammer,
Figur 2 einen Querschnitt einer Vorrichtung (II) zum Befüllen einer Selenverdampferkammer nach dem Stand der Technik und
Figur 3 ein Fließdiagramm des erfindungsgemäßen Verfahrens zum Befüllen einer Selenverdampferkammer.

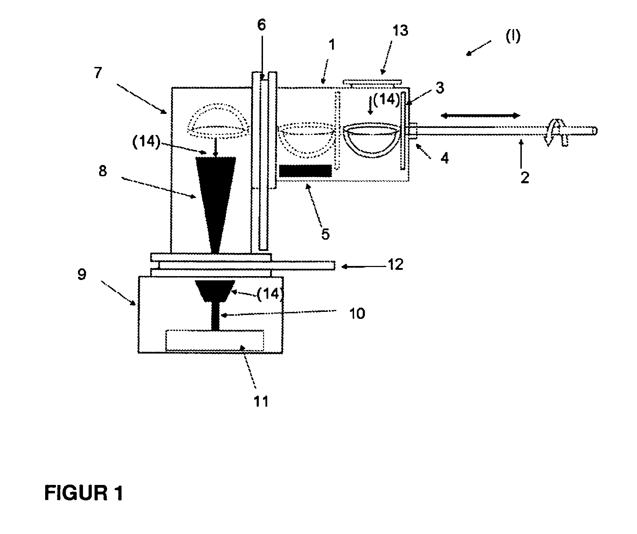

Figur 1 zeigt einen Querschnitt der erfindungsgemäßen Vorrichtung (1) aus Vorkammer (1), Gießkammer (7) und Verdampferkammer (9). Die Vorkammer (1) und die Gießkammer (7), sowie die Gießkammer (7) und die Verdampferkammer (9) sind durch beheizte Vakuumschieber (6) und (12) verbunden und bevorzugt aus Edelstahl gefertigt. Die Vorkammer (1) enthält einen an einer Dichtung (4) befestigten, horizontal freibeweglichen Dosierbehälter (2). Die Länge des Stiels des Dosierbehälters (2) ist so gewählt, dass der Dosierbehälter (2) sowohl in der Vorkammer (1) als auch in der Gießkammer (7) horizontal frei bewegt werden kann. Die Vorkammer (1) umfasst des Weiteren eine verschließbare Öffnung (13), über die Selen (14) in den Dosierbehälter (2) nachgefüllt werden kann. Eine in der Vorkammer (1) angeordnete Heizung (5), beispielsweise ein Infrarotstrahler, ermöglicht ein Verflüssigen des Selens in der geschlossenen und auf etwa 10⁻² mbar bis 10-' mbar evakuierten Vorkammer (1). Das verflüssigte Selen (14) wird in der Gießkammer (7) nach Öffnen des geheizten Vakuumschiebers (6) in einen beheizten Trichter (8) überführt. Die Gießkammer (7) wird auf 150°C bis 180 °C temperiert und wie die Vorkammer auf einen Druck von 10⁻² mbar bis 10⁻⁷ mbar evakuiert. Das verflüssigte Selen (14) gelangt durch Öffnen des beheizten Vakuumschiebers (12) in einen beheizten Trichter (10) und in einen Selenverdampfer (11) in der Verdampferkammer (9). Die Verdampferkammer (9) sowie die beheizten Trichter (8) und (10) werden auf 230 ºC bis 250 ºC temperiert und auf einen Druck von 10⁻² mbar bis 10⁻⁷ mbar evakuiert. Die Trichter (8) und/oder Trichter (10) weisen bevorzugt eine Email- oder Teflonbeschichtung auf.

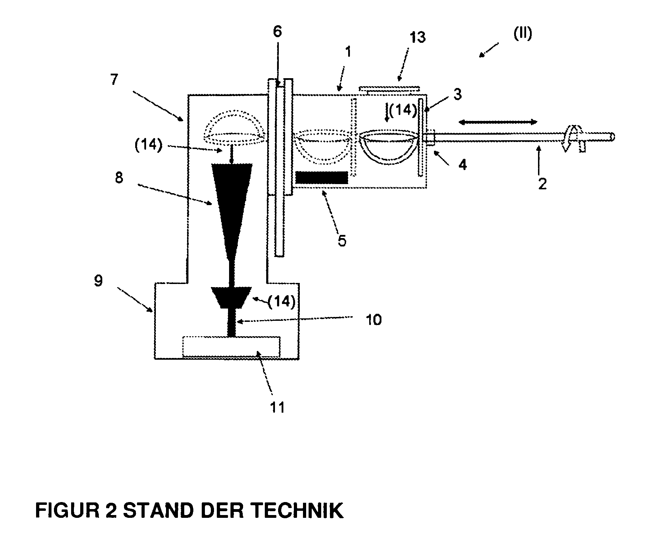

Figur 2 zeigt einen Querschnitt der Vorrichtung (11) zum Befüllen einer Selenverdampferkammer nach dem Stand der Technik. Der Aufbau aus Vorkammer (1) und Gießkammer (7) entspricht dem in Figur 1 beschriebenen. Die Gießkammer (7) ist jedoch nicht wie im erfindungsgemäßen Aufbau in Figur 1 gezeigt, durch einen beheizten Vakuumschieber (12 in Figur 1) von der Selenverdampferkammer (9) getrennt. Selendämpfe aus einem in der Selenverdampferkammer (9) angeordneten Selenverdampfer (11) und die auf 230°C bis 250°C beheizten Trichter (8) und (10) können sich aus diesem Grund in der Gießkammer (7) festsetzen. Dieses abgeschiedene Selen (14) muss in häufigen Reinigungsschritten entfernt werden.

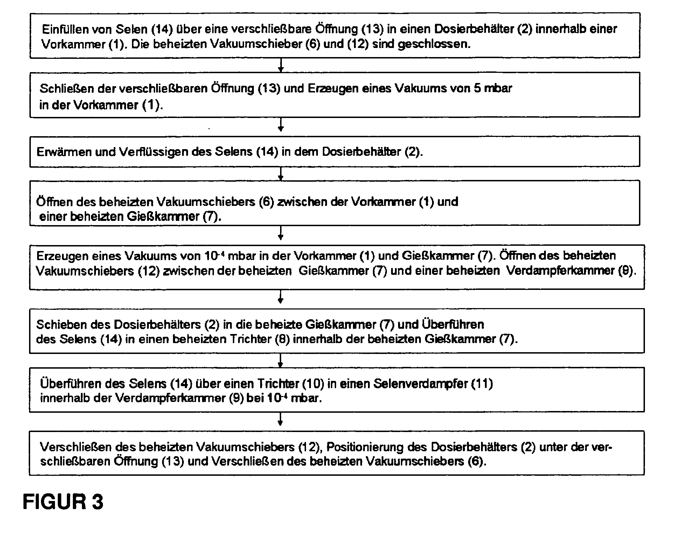

Figur 3 zeigt ein Fließdiagramm des erfindungsgemäßen Verfahrens zum Befüllen einer Selenverdampferkammer. Das Verfahren umfasst in einem ersten Schritt das Befüllen eines Dosierbehälters (2) in einer Vorkammer (1) mit 300 g Selen (14) über eine verschließbare Öffnung (13). Die verschließbare Öffnung (13) wird anschließend geschlossen und in der Vorkammer (1) wird ein Vakuum von 5 mbar erzeugt. Der Dosierbehälter (2) wird anschließend in der Vorkammer auf 230 °C erwärmt und das Selen (14) im Dosierbehälter (2) verflüssigt. Im nächsten Schritt wird ein beheizter Vakuumschieber (6) zwischen der Vorkammer (1) und einer beheizten Gießkammer (7) geöffnet. In der Vorkammer (1) und in der Gießkammer (7) wird ein Vakuum von etwa 10-⁴ mbar erzeugt. Anschließend wird ein beheizter Vakuumschieber (12) zwischen der beheizten Gießkammer (7) und einer beheizten Verdampferkammer (9) geöffnet. Der Dosierbehälter (2) wird in die beheizte Gießkammer (7) geschoben und das Selen (14) durch Drehen des Dosierbehälters (2) um 90° in einen beheizten Trichter (8) innerhalb der beheizten Gießkammer (7) überführt. Das Selen (14) wird aus dem beheizten Trichter (8) über einen beheizten Trichter (10) in einen Selenverdampfer (11) innerhalb der beheizten Verdampferkammer (9) überführt und verdampft. Die beheizte Verdampferkammer (9) weist einen Druck von 10-⁴ mbar und eine Temperatur von 230 °C auf. In einem abschließenden Schritt werden der beheizte Vakuumschieber (12) geschlossen, der Dosierbehälter (2) unter der verschließbaren Öffnung (13) positioniert und der beheizte Vakuumschieber (6) geschlossen. Die Vorkammer (1) kann anschließend wieder belüftet und neu befüllt werden.

Ein beispielhaftes Verfahren zur diskontinuierlichen Selen-Nachfüllung sieht wie folgt aus:
1. Festes Selen (14) wird durch die verschließbare Öffnung (13) der Vorkammer (1) in den Dosierbehälter (2) bei 1 atm und 30°C eingefüllt (jeweils 300 g, alle 5 min).
2. Die verschließbare Öffnung (13) wird geschlossen und die Vorkammer (1) mit dem festen Selen wird von 1 atm auf 5 mbar evakuiert.
3. Das feste Selen (14) in dem Dosierbehälter (2) wird in der Vorkammer (1) über die Heizung (5) geschoben und auf eine Temperatur oberhalb des Schmelzpunkts von Selen, etwa 220°C, erhitzt.
4. Öffnen des beheizten Vakuumschiebers (6) zwischen Vorkammer (1) und Gießkammer (7).
5. Evakuieren der Vorkammer (1) und der Gießkammer (7) auf 10-⁴ mbar.
6. Schieben des Dosierbehälters (2) mit dem flüssigen Selen (14) über den beheizten Trichter (8) in der Gießkammer (7).
7. Öffnen des beheizten Vakuumschiebers (12) zwischen Gießkammer (7) und Verdampferkammer (9).
8. Drehen des Dosierbehälters (2) um 90°, damit das flüssige Selen (14) durch den beheizten Trichter (8) in der Gießkammer (7) und dann weiter durch den beheizten Trichter (10) in der Verdampferkammer (9) in den Selenverdampfer (11) fließt.
9. Schließen des beheizten Vakuumschiebers (12) zwischen Gießkammer (7) und Verdampferkammer (9).
10. Zurückdrehen des Dosierbehälters (2) um 90° und Zurückziehen des Dosierbehälters (2) aus der Gießkammer (7) in die Vorkammer (1).
11. Schließen des beheizten Vakuumschiebers (6) zwischen Vorkammer (1) und Gießkammer (7).
12. Belüften der Vorkammer (1) von 10⁻⁴ mbar auf 1 atm.
13. Öffnen der verschließbaren Öffnung (13) der Vorkammer (1) zum erneuten Einfüllen von Selen (14) in den Dosierbehälter (2).

Es zeigen:
- (I): Erfindungsgemäße Vorrichtung
- (II): Vorrichtung nach dem Stand der Technik
- (1): Vorkammer
- (2): Dosierbehälter
- (3): Dampfschild
- (4): Dichtung
- (5): Heizung
- (6): beheizter Vakuumschieber
- (7): Gießkammer
- (8): beheizter Trichter
- (9): Verdampferkammer
- (10): beheizter Trichter
- (11): Selenverdampfer
- (12): beheizter Vakuumschieber
- (13): verschließbare Öffnung und
- (14): Selen

## Patentansprüche

1. Verfahren zum diskontinuierlichen Nachfüllen einer Selenverdampferkammer (9), wobei :
a. ein Dosierbehälter (2) in einer Vorkammer (1) über eine verschließbare Öffnung (13) mit Selen (14) befüllt wird, nach Befüllen des Dosierbehälters (2), die verschließbare Öffnung (13) geschlossen wird und ein Vakuum erzeugt wird und das Selen (14) über einer Heizung (5) verflüssigt wird,
b. ein beheizter Vakuumschieber (6) zwischen der Vorkammer (1) und einer beheizten Gießkammer (7) geöffnet wird, der Dosierbehälter (2) in die Gießkammer (7) geschoben wird und das Selen (14) durch Drehen oder Öffnen vom Dosierbehälter (2) in einen beheizten Trichter (8) überführt wird und wobei
c. ein beheizter Vakuumschieber (12) zwischen der Gießkammer (7) und einer beheizten Verdampferkammer (9) geöffnet wird und das Selen (14) aus dem Trichter (8) über einen Trichter (10) in der Verdampferkammer (9) in einen Selenverdampfer (11) überführt wird.

2. Verfahren nach Anspruch 1, wobei die Vorkammer (1) und/oder die Gießkammer (7) auf 150°C bis 250°C erwärmt werden.

3. Verfahren nach Anspruch 1 oder 2, wobei die Vorkammer (1), die Gießkammer (7) und/oder die Verdampferkammer (9) auf weniger als 5 mbar, bevorzugt weniger als 0,1 mbar, besonders bevorzugt auf weniger als 10⁻³ mbar evakuiert werden.

4. Verfahren nach einem der Ansprüche 1 bis 3, wobei die Verdampferkammer (9) auf 190°C bis 280 °C, bevorzugt 200°C bis 250°C erwärmt wird.

5. Vorrichtung zum diskontinuierlichen Nachfüllen einer Selenverdampferkammer (9), umfassend:
a. mindestens eine Vorkammer (1) mit einem an einer Dichtung (4) befestigten, horizontal freibeweglichen, Dosierbehälter (2) und mindestens einer Heizung (5),
b. eine an die Vorkammer (1) angrenzende beheizte Gießkammer (7) mit einem am Boden angeordneten beheizten Trichter (8) und mindestens einem zwischen der Vorkammer (1) und der beheizten Gießkammer (7) angeordneten, verschließbaren, beheizten Vakuumschieber (6) und
c. eine an die Gießkammer (7) angrenzende beheizte Selenverdampferkammer (9) mit einem am Boden angeordneten Selenverdampfer (11), einem auf dem Selenverdampfer (11) angeordneten beheizten Trichter (10) und mindestens einem zwischen der beheizten Gießkammer (7) und der beheizten Gießkammer (9) angeordneten beheizten Vakuumschieber (12), wobei der beheizte Vakuumschieber (12) eine verschließbare Verbindung zwischen dem beheizten Trichter (8) und dem beheizten Trichter (10) ist.

6. Vorrichtung nach Anspruch 5, wobei der Dosierbehälter (2) ein Dampfschild (3) enthält.

7. Vorrichtung nach Anspruch 5 oder 6, wobei der Dosierbehälter (2) eine Email- oder Teflonbeschichtung enthält.

8. Vorrichtung nach einem der Ansprüche 5 bis 7, wobei die Vorkammer (1) eine verschließbare Öffnung (13) enthält.

9. Vorrichtung nach einem der Ansprüche 5 bis 8, wobei die Heizung (5) einen Infrarotheizer enthält.

10. Vorrichtung nach einem der Ansprüche 5 bis 9, wobei die Vorkammer (1) Ventile zum Evakuieren und/oder Belüften enthält.

11. Vorrichtung nach einem der Ansprüche 5 bis 10, wobei der Dosierbehälter (2) ein Füllvolumen von 30 cm³ bis 250 cm³, bevorzugt 50 cm³ bis 150 cm³ aufweist.

12. Vorrichtung nach einem der Ansprüche 5 bis 11, wobei die Vorkammer (1) und/oder Gießkammer (7) eine Ummantelung aus Metallen, besonders bevorzugt Eisen, Chrom, Vanadium, Nickel, Kobalt, Titan, Aluminium, ganz besonders bevorzugt aus Stahl oder Legierungen davon enthält.

13. Vorrichtung nach einem der Ansprüche 5 bis 12, wobei die Vorkammer (1) und/oder Gießkammer (7) ein Volumen von 30 cm³ bis 250 cm³, bevorzugt 50 cm³ bis 150 cm³ aufweisen.

14. Verwendung der Vorrichtung nach einem der Ansprüche 5 bis 13 zum diskontinuierlichen Nachfüllen einer Selenverdampferkammer, bevorzugt bei der Herstellung von Dünnschichtsolarzellen.

15. Verwendung der Vorrichtung nach einem der Ansprüche 5 bis 13 zum diskontinuierlichen Nachfüllen einer Verdampferkammer für Schwefel, Selen, Tellur und/oder Gemischen davon, bevorzugt bei der Herstellung von Dünnschichtsolarzellen.

## Claims

1. Method for discontinuously refilling a selenium evaporator chamber (9), wherein:
a. a metering container (2) in a prechamber (1) is filled with selenium (14) via a lockable opening (13), the lockable opening (13) is closed after filling the metering container (2), and a vacuum is generated and the selenium (14) is liquefied by a heater (5),
b. a heated vacuum slide (6) is opened between the prechamber (1) and a heated casting chamber (7), the metering container (2) is pushed into the casting chamber (7), and the selenium (14) is transferred into a heated funnel (8) by rotating or opening the metering container (2), and wherein
c. a heated vacuum slide (12) is opened between the casting chamber (7) and a heated evaporator chamber (9), and the selenium (14) is transferred out of the funnel (8) via a funnel (10) in the evaporator chamber (9) into a selenium evaporator (11).

2. Method according to claim 1, wherein the prechamber (1) and/or the casting chamber (7) are heated to 150 °C to 250 °C.

3. Method according to claim 1 or 2, wherein the prechamber (1), the casting chamber (7), and/or the evaporator chamber (9) are evacuated to less than 5 mbar, preferably less than 0.1 mbar, particularly preferably to less than 10⁻³ mbar.

4. Method according to one of claims 1 through 3, wherein the evaporator chamber (9) is heated to 190 °C to 280 °C, preferably 200 °C to 250°C.

5. Device for discontinuously refilling a selenium evaporator chamber (9), comprising:
a. at least one prechamber (1) with a metering container (2) fixed horizontally movable on a sealing gasket (4) and at least one heater (5),
b. adjacent the prechamber (1), a heated casting chamber (7) with a heated funnel (8) disposed on the floor and at least one lockable heated vacuum slide (6) disposed between the prechamber (1) and the heated casting chamber (7), and
c. adjacent the casting chamber (7), a heated selenium evaporator chamber (9) with a selenium evaporator (11) disposed on the floor, a heated funnel (10) disposed on the selenium evaporator (11), and at least one heated vacuum slide (12) disposed between the heated casting chamber (7) and the heated casting chamber (9), wherein the heated vacuum slide (12) is a lockable connection between the heated funnel (8) and the heated funnel (10).

6. Device according to claim 5, wherein the metering container (2) includes a vapor shield (3).

7. Device according to claim 5 or 6, wherein the metering container (2) includes an enamel or Teflon coating.

8. Device according to one of claims 5 through 7, wherein the prechamber (1) includes a lockable opening (13).

9. Device according to one of claims 5 through 8, wherein the heater (5) includes an infrared heater.

10. Device according to one of claims 5 through 9, wherein the prechamber (1) includes valves for evacuation and/or ventilation.

11. Device according to one of claims 5 through 10, wherein the metering container (2) has a fill volume of 30 cm³ cubed to 250 cm³, preferably 50 cm³ to 150 cm³.

12. Device according to one of claims 5 through 11, wherein the prechamber (1) and/or casting chamber (7) includes a jacket made of metals, particularly preferably iron, chromium, vanadium, nickel, cobalt, titanium, aluminum, quite particularly preferably made of steel or alloys thereof.

13. Device according to one of claims 5 through 12, wherein the prechamber (1) and/or casting chamber (7) has/have a volume of 30 cm³ to 250 cm³, preferably 50 cm³ to 150 cm³.

14. Use of the device according to one of claims 5 through 13 for discontinuously refilling a selenium evaporator chamber, preferably during the production of thin-film solar cells.

15. Use of the device according to one of claims 5 through 13 for discontinuously refilling an evaporator chamber for sulfur, selenium, tellurium, and/or mixtures thereof, preferably during the production of thin-film solar cells.

## Revendications

1. Procédé de rechargement discontinu d'une chambre d'évaporateur de sélénium (9), dans lequel :
a. un récipient de dosage (2) placé dans une préchambre (1) est rempli de sélénium (14) en passant par une ouverture refermable (13), après remplissage du récipient de dosage (2), l'ouverture refermable (13) est refermée et un vide est produit et le sélénium (14) est liquéfié à l'aide d'un chauffage (5) ;
b. un registre pour vide chauffé (6) est ouvert entre la préchambre (1) et une chambre de coulée chauffée (7), le récipient de dosage (2) est poussé dans la chambre de coulée (7) et le sélénium (14) est transvasé dans un entonnoir chauffé (8) par rotation ou ouverture du récipient de dosage (2) ; et
c. un registre pour vide chauffé (12) entre la chambre de coulée (7) et une chambre d'évaporateur chauffée (9) est ouvert et le sélénium (14) est transvasé à partir de l'entonnoir (8), à l'aide d'un entonnoir (10), dans un évaporateur de sélénium (11) placé dans la chambre d'évaporateur (9).

2. Procédé selon la revendication 1, dans lequel la préchambre (1) et/ou la chambre de coulée (7) est chauffée à une température de 150°C à 250°C.

3. Procédé selon l'une des revendications 1 ou 2, dans lequel la préchambre (1), la chambre de coulée (7) et/ou la chambre d'évaporateur (9) sont mises sous vide à une pression inférieure à 5 mbar, de préférence inférieure à 0,1 mbar et de façon particulièrement préférée à moins de 10⁻³ mbar.

4. Procédé selon l'une des revendications 1 à 3, dans lequel la chambre d'évaporateur (9) est chauffée à une température de 190°C à 280°C, de préférence de 200°C à 250°C.

5. Dispositif pour le rechargement discontinu d'une chambre d'évaporateur de sélénium (9), comprenant :
a. au moins une préchambre (1) comportant un récipient de dosage (2) fixé sur un joint (4) et pouvant se déplacer librement horizontalement et au moins un chauffage (5) ;
b. une chambre de coulée chauffée (7) adjacente à la préchambre (1), comportant un entonnoir chauffé (8) implanté sur le plancher et au moins un registre pour vide (6), chauffé et refermable, placé entre la préchambre (1) et la chambre de coulée chauffée (7) ; et
c. une chambre d'évaporateur de sélénium chauffée (9), adjacente à la chambre de coulée (7), comportant un évaporateur de sélénium (11) implanté sur le plancher, un entonnoir (10) chauffé disposé sur l'évaporateur de sélénium (11) et au moins un registre pour vide chauffé (12) implanté entre la chambre de coulée chauffée (7) et la chambre d'évaporateur chauffée (9), le registre pour vide chauffé (12) constituant une liaison pouvant être fermée entre l'entonnoir chauffé (8) et l'entonnoir chauffé (10).

6. Dispositif selon la revendication 5, dans lequel le récipient de dosage (2) comporte une barrière de vapeur (3).

7. Dispositif selon l'une des revendications 5 ou 6, dans lequel le récipient de dosage (2) possède un revêtement d'émail ou de téflon.

8. Dispositif selon l'une des revendications 5 à 7, dans lequel la préchambre (1) possède une ouverture refermable (13).

9. Dispositif selon l'une des revendications 5 à 8, dans lequel le chauffage (5) comprend un chauffage à infrarouges.

10. Dispositif selon l'une des revendications 5 à 9, dans lequel la préchambre (1) comporte des vannes pour la mise sous vide et/ou la mise à l'atmosphère.

11. Dispositif selon l'une des revendications 5 à 10, dans lequel le récipient de dosage (2) offre un volume de remplissage de 30 cm³ à 250 cm³, de préférence de 50 cm³ à 150 cm³.

12. Dispositif selon l'une des revendications 5 à 11, dans lequel la préchambre (1) et/ou la chambre de coulée (7) comportent un chemisage métallique, de façon particulièrement préférée en fer, en chrome, en vanadium, en nickel, en cobalt, en titane, en aluminium, de façon tout particulièrement préférée en acier ou en alliages de celui-ci.

13. Dispositif selon l'une des revendications 5 à 12, dans lequel la préchambre (1) et/ou la chambre de coulée (7) offrent un volume de 30 cm³ à 250 cm³, de préférence de 50 cm³ à 150 cm³.

14. Utilisation du dispositif selon l'une des revendications 5 à 13 pour le rechargement discontinu d'une chambre d'évaporateur de sélénium, de préférence pour la fabrication de cellules solaires à couches minces.

15. Utilisation du dispositif selon l'une des revendications 5 à 13 pour le rechargement discontinu d'une chambre d'évaporateur pour du soufre, du sélénium, du tellure et/ou des mélanges de ceux-ci, de préférence pour la fabrication de cellules solaires à couches minces.
